# FASCICULE DE BREVET EUROPEEN

(11) **EP 3 713 723 B1**
(45) Date de publication et mention de la délivrance du brevet: **23.08.2023**
(21) Numéro de dépôt: 18800671.2
(22) Date de dépôt: 19.11.2018
(51) Int. Cl.: B25J 15/06, B25J 9/16, B25J 13/08, B25J 19/06

(54) **DISPOSITIF DE PRÉHENSION AVEC SURVEILLANCE DE SON ÉTAT DE FONCTIONNEMENT**
GREIFVORRICHTUNG MIT ÜBERWACHUNG DES BETRIEBSZUSTANDS DAVON
GRIPPING DEVICE WITH MONITORING OF THE OPERATING STATE THEREOF

(30) Priorité: 22.11.2017 FR 1761045
(43) Date de publication de la demande: 30.09.2020
(73) Titulaire: COVAL, 26120 Montelier (FR)
(72) Inventeur: MILHAU, Pierre, 26300 Chatuzange-Le-Goubet (FR); CECCHIN, Michel, 26120 Montelier (FR)
(74) Mandataire: Lavialle, Bruno François Stéphane
(86) Numéro de dépôt international: PCT/EP2018/081694
(87) Numéro de publication internationale: WO 2019/101668

(56) Documents cités:
- EP-A1- 2 835 085
- DE-A1-102015 009 998
- JP-A- H11 114 863
- JP-A- 2008 149 435

## Description

La présente invention concerne le domaine de la préhension d'objets notamment dans l'industrie.

### ETAT DE LA TECHNIQUE

Il est connu des dispositifs de préhension comprenant des ventouses comportant un corps de fixation à partir duquel s'étend une jupe élastiquement déformable ayant un bord annulaire libre destiné à venir au contact d'un objet à saisir. Les corps de fixation, de forme tubulaire, sont montés sur un bâti mobile et sont reliés individuellement ou collectivement à une source de vide. Le bâti mobile est par exemple monté sur l'extrémité mobile d'un robot piloté pour déplacer l'objet depuis une position initiale, dans laquelle la source de vide est activée et les ventouses sont appliquées contre l'objet, vers une position finale dans laquelle la source de vide est désactivée de sorte que l'objet est libéré des ventouses. Eventuellement, en position finale, de l'air est expulsé par la ventouse pour accélérer la libération de l'objet.

Lors de la prise de l'objet, le bord annulaire de la jupe est appliqué sur la surface extérieure de l'objet délimitant ainsi une chambre étanche dont l'air est aspiré par le générateur de vide. L'objet se trouve alors entraîné vers le bâti mobile en provoquant une déformation (similaire à un écrasement) de la jupe. Cette déformation se répète à chaque cycle de prise et de relâchement de l'objet. L'accroissement du nombre de cycles subis finit par provoquer par fatigue une fissuration de la jupe. Il en résulte des difficultés pour maintenir le vide dans la chambre étanche formée lors de la prise de l'objet, ce qui augmente la consommation d'air et risque à terme d'empêcher la saisie de l'objet.

Il est connu du document EP-A-2835085 une ventouse ayant une embase pourvue d'une jauge de contrainte.

DE 102015009998 divulgue une ventouse avec une piste électriquement conductrice élastique solidaire de la jupe.

### OBJET DE L'INVENTION

Un but de l'invention est de fournir un moyen pour améliorer la fiabilité du dispositif de préhension.

### BREF EXPOSE DE L'INVENTION

A cet effet, on prévoit, selon l'invention, un dispositif de préhension par le vide comprenant au moins une ventouse (100) comportant un corps de fixation (110) à partir duquel s'étend une jupe (120) élastiquement déformable ayant un bord annulaire libre (122) destiné à venir au contact d'un objet à saisir, la ventouse comprenant au moins une piste électriquement conductrice (200) solidaire au moins de la jupe, la piste conductrice étant en un matériau élastiquement conducteur et élastiquement déformable pour se déformer avec la jupe, le dispositif comprenant un circuit électronique de traitement (300) qui est électriquement relié à deux plages de connexion (210) appartenant à la piste électriquement conductrice et qui est agencé pour surveiller une propriété électrique de la piste conductrice, la propriété électrique variant avec la déformation de la piste conductrice, et la comparer à des données de référence de manière à anticiper une défaillance de la ventouse.

Ainsi, la jupe et la piste conductrice se déforment ensemble et la propriété électrique varie avec la déformation. Il en résulte que la surveillance de la propriété électrique permet de compter le nombre de cycles. En outre, il est possible à partir d'essais de déterminer une évolution normale de la propriété électrique de sorte qu'une évolution anormale de cette même propriété électrique serait révélatrice d'une anomalie, comme un vieillissement ou une usure du matériau constituant la piste conductrice.

La propriété électrique est par exemple la résistance.

La résistance de la piste conductrice dépend de la section de ladite piste. La déformation entraîne une diminution de cette section et donc de la résistance de la piste conductrice.

Avantageusement, les plages de connexion de la piste conductrice sont solidaires du corps.

Le corps étant une partie fixe de la ventouse, la connexion est plus aisée à réaliser et subit relativement peu de sollicitations, ce qui la rend plus fiable.

D'autres caractéristiques et avantages de l'invention ressortiront à la lecture de la description qui suit de modes de réalisation particuliers non limitatifs de l'invention.

### BREVE DESCRIPTION DES FIGURES

Il sera fait référence aux dessins annexés, parmi lesquels :

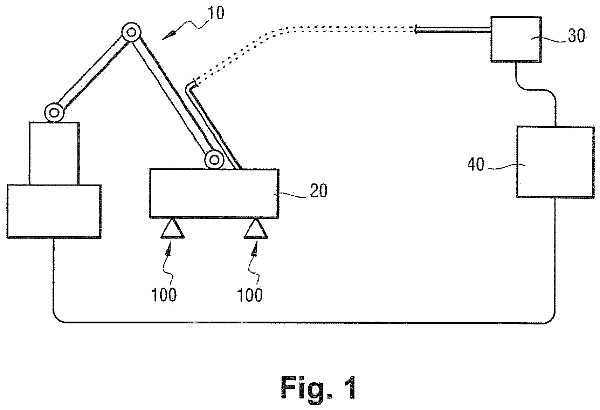

- la figure 1 est une vue schématique en perspective d'un dispositif de préhension selon l'invention ;
- la figure 2 est une vue en perspective d'une ventouse selon un premier mode de réalisation de ce dispositif ;
- la figure 3 est une vue schématique en perspective d'une ventouse selon un deuxième mode de réalisation de ce dispositif.

### DESCRIPTION DETAILLEE DE L'INVENTION

En référence aux figures, le dispositif de préhension par le vide selon l'invention comprend un robot manipulateur 10 ayant une partie mobile portant un caisson 20, étanche, définissant un conduit relié à une source de vide 30. Le robot manipulateur 10 et la source de vide 30 sont pilotés par une unité électronique de commande 40. Ce type d'agencement est connu en lui-même et ne sera pas plus détaillé ici.

Le caisson 20 est pourvu de ventouses généralement désignées en 100. Chaque ventouse 100 comporte un corps de fixation 110 à partir duquel s'étend une jupe 120 élastiquement déformable. Le corps de fixation 110 est de forme tubulaire et reçoit un insert tubulaire métallique permettant la fixation de la ventouse 100 au caisson 20 et la mise en communication fluidique de la ventouse 100 avec le conduit relié à la source de vide 30. La jupe 120 comprend une partie principale, en forme de soufflet annulaire sensiblement tronconique, en matériau élastiquement déformable et électriquement isolant, ayant un bord 121 de petite section raccordé au corps de fixation 110 et un bord 122 de grande section formant un bord annulaire libre de la jupe 120 destiné à venir au contact d'un objet à saisir. Le corps de fixation 110 et la jupe 120 de la ventouse 100 sont ici en une seule pièce d'un matériau élastomère tel que le nitrile.

Chaque ventouse 100 comprend au moins une piste électriquement conductrice 200 qui possède des plages de connexion 210, solidaires du corps de fixation 110, et un tronçon principal 220 qui est solidaire de la partie principale de la jupe 120 et qui relie les plages de connexion 210 l'une à l'autre. Chaque piste conductrice 200 est en un matériau élastiquement conducteur et élastiquement déformable pour se déformer avec la jupe 120.

La piste électriquement conductrice 200 comprend ici une couche de matériau électriquement conducteur fixée sur la partie principale de la jupe 120 et sur le corps de fixation 110. Le matériau électriquement conducteur (qui inclut également les matériaux semi-conducteurs) est déposé sur la surface externe de la ventouse 200 (mais pourrait l'être alternativement ou également sur la surface interne) sous la forme d'une couche plus ou moins fine, d'épaisseur constante ou non. La souplesse de la couche de matériau électriquement conducteur est de préférence identique à celle du matériau constituant la jupe de la ventouse. La couche conductrice (ou semi-conductrice) peut être de différentes natures et peut être déposée suivant différents procédés comme par exemple :
- dépôt ou projection d'une peinture conductrice (ou semi-conductrice) ;
- dépôt, projection, pulvérisation, transfert d'une encre conductrice (ou semi-conductrice) ;
- dépôt ou projection (bombardement plasma) de particules conductrices.

Cette liste n'est pas exhaustive, il existe d'autres substances ou composés et d'autres méthodes de dépôts possibles

Dans certains cas, la couche électriquement conductrice déposée sur la ventouse, pourra être isolée et protégée des attaques chimiques de l'environnement, par l'ajout d'une surcouche d'un agent de protection comme un vernis ou autre...

Cette couche adhérente est préférentiellement positionnée sur les zones à risques de la ventouse suivant des formes de dessins variées.

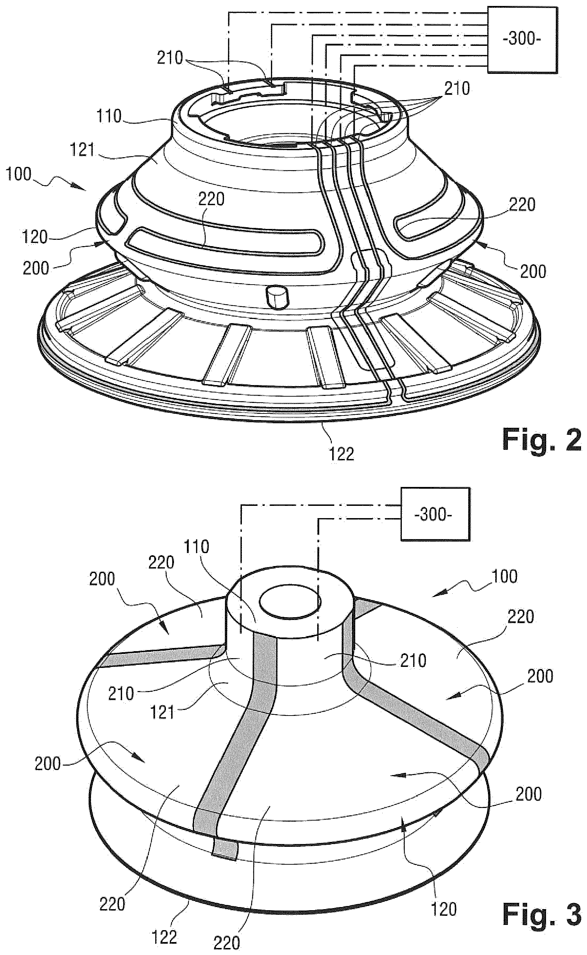

Sur la figure 2, le tronçon principal 220 de la piste électriquement conductrice 200 a une forme de bande longue et étroite s'étendant circonférentiellement sur la partie principale de la jupe 120 en formant des circonvolutions du bord annulaire 122 au bord annulaire 121.

Sur la figure 3, le tronçon principal 220 de la piste électriquement conductrice 200 a une forme surfacique et forme plus particulièrement un secteur angulaire. Les pistes conductrices sont nombre de quatre : les quatre secteurs sont séparés deux à deux en partie supérieure par une portion électriquement isolante et sont reliés ensemble le long du bord 122.

Ces formes ne sont pas limitatives et dépendent aussi de la forme géométrique de la ventouse et des zones à surveiller. La piste électriquement conductrice pourrait ainsi également combiner des formes linéaires et des formes surfaciques.

Le dispositif comprend, ici pour chaque ventouse 100, un circuit électronique de traitement 300 qui est électriquement relié aux deux plages de connexion 210 appartenant à la piste conductrice 200 et qui est agencé pour surveiller une propriété électrique de la piste conductrice 200, la propriété électrique variant avec la déformation de la piste conductrice 200, et la comparer à des données de référence de manière à anticiper une défaillance de la ventouse. La propriété électrique surveillée est une valeur de résistance. Les données de référence comprennent des valeurs de résistance en fonction d'un nombre de cycles de déformation. Le circuit électronique de traitement 300 comprend un organe de mesure de résistance (ohmmètre), une mémoire contenant un programme de traitement, des données de référence et des données mesurées, un processeur qui exécute le programme de traitement et qui est relié à l'organe de mesure de courant, et une batterie pour alimenter le tout. Le programme de traitement est agencé pour mesurer périodiquement la résistance de la piste conductrice 200, identifier un cycle de déformation (ou cycle de fonctionnement qui comprend, lors de l'aspiration, une déformation d'un état de repos à un état déformé puis, lors du relâchement, une déformation de l'état déformé à l'état de repos) à partir de l'évolution de la valeur de résistance mesurée, déterminer un nombre de cycles de déformation déjà effectués, comparer les valeurs de résistance mesurées pour ce nombre de cycles de déformation aux données de référence et émettre une alerte quand le nombre de cycles de déformation atteint un seuil prédéterminé et/ou quand les valeurs de résistance mesurées sont différentes de celles des données de référence. Le programme de traitement peut être agencé différemment et, par exemple dans une version plus simple, pour mesurer périodiquement la résistance de la piste conductrice 200, comparer les valeurs de résistance mesurées et leur évolution aux données de référence et émettre une alerte quand les valeurs de résistance mesurées et/ou leur évolution sont différentes de celles des données de référence. Le circuit électronique de traitement 300 est ici monté sur le corps de fixation 110 de la ventouse 100. Le circuit électronique de traitement 300 est également pourvu d'un organe de connexion à l'unité électronique de commande 40 du dispositif. L'organe de connexion peut être agencé pour établir une liaison filaire ou une liaison sans fil avec l'unité électronique de commande 40.

La section de la couche de matériau électriquement conducteur et le matériau électriquement conducteur lui-même définissent une valeur de résistance lorsque la ventouse est à l'état de repos (c'est-à-dire non déformée).

Lorsque la ventouse est en exploitation, la jupe 120 de la ventouse 100 et le tronçon principal 220 de la couche électriquement conductrice 200 se déforment ensemble sous l'effet de la dépression et des contraintes mécaniques du cycle de préhension. Il en résulte que la résistance mesurée évolue en temps réel, générant ainsi une courbe dynamique du cycle en fonction du temps. En vieillissant après plusieurs milliers de cycles, le polymère de la ventouse se dégrade. Il existe plusieurs causes de dégradations, notamment chimiques et mécaniques, qui auront pour conséquences de modifier le comportement dynamique de la déformation de la ventouse et donc de facto de la courbe résistive mesurée. En comparant la courbe résistive de la piste électriquement conductrice de la ventouse à l'état neuf lors des premiers cycles (formant une courbe résistive de référence) et la courbe résistive de la piste électriquement conductrice de la ventouse après plusieurs milliers de cycles, éventuellement en tenant compte de caractéristiques de vieillissement théoriques ou déterminées empiriquement, il sera alors possible de diagnostiquer l'état plus ou moins avancé de fatigue de la ventouse et de prévenir ainsi les opérateurs et le service de maintenance des risques imminents de défaillance. On peut ainsi éviter d'attendre une détérioration grave de la ventouse pour procéder à son remplacement en planifiant une opération de maintenance préventive.

Evidemment, l'invention permet également de détecter toute détérioration de la ventouse ayant entraîné une diminution locale de la section de la piste électriquement conductrice, comme une déchirure de la ventouse ou une abrasion excessive du bord 122 de la ventouse.

A noter que la piste électriquement couche conductrice peut fonctionner comme un capteur de pression. En effet, l'écart type de résistance mesurée entre une ventouse à l'état repos et la même ventouse soumis au vide, permettra de donner une indication de la valeur de la dépression qui y règne.

Bien entendu, l'invention n'est pas limitée aux modes de réalisation décrits mais englobe toute variante entrant dans le champ de l'invention telle que définie par les revendications.

En particulier, la structure du dispositif peut être différente de celle décrite.

Le dispositif peut par exemple comprendre un éjecteur à venturi ou une pluralité d'éjecteurs à venturi pourvu chacun d'une ou plusieurs ventouses.

La piste conductrice 200 peut s'étendre uniquement sur la jupe.

Dans le cas d'un dispositif comprenant plusieurs ventouses pourvues chacune d'une piste conductrice, le circuit électronique de traitement peut être commun à plusieurs ventouses et donc relié aux pistes conductrices de ces ventouses.

Le circuit électronique de traitement 300 peut être intégré à l'unité électronique de commande du dispositif ou être déportée par rapport à celle-ci.

Le circuit électronique de traitement peut se trouver dans la ventouse elle-même, dans l'insert de la ventouse ou au contraire être détaché de la ventouse.

La ventouse peut avoir une forme différente de celle décrite et par exemple une section transversale circulaire ou oblongue, une forme à soufflet unique ou soufflet multiple, ou autre.

## Revendications

1. Dispositif de préhension par le vide comprenant au moins une ventouse (100) comportant un corps de fixation (110) à partir duquel s'étend une jupe (120) élastiquement déformable ayant un bord annulaire libre (122) destiné à venir au contact d'un objet à saisir, la ventouse comprenant au moins une piste électriquement conductrice (200) solidaire au moins de la jupe, la piste conductrice étant en un matériau élastiquement conducteur et élastiquement déformable pour se déformer avec la jupe, le dispositif comprenant un circuit électronique de traitement (300) qui est électriquement relié à deux plages de connexion (210) appartenant à la piste électriquement conductrice et qui est agencé pour surveiller une propriété électrique de la piste conductrice, la propriété électrique variant avec la déformation de la piste conductrice, et la comparer à des données de référence de manière à anticiper une défaillance de la ventouse.

2. Dispositif selon la revendication 1, dans lequel les plages de connexion (210) de la piste conductrice (200) sont solidaires du corps de fixation (110) .

3. Dispositif selon la revendication 1 ou la revendication 2, dans lequel la jupe (120) comprend une partie principale, de forme annulaire, en matériau élastiquement déformable et électriquement isolant, et la piste électriquement conductrice (200) comprend une couche de matériau électriquement conducteur fixée sur la partie principale.

4. Dispositif selon la revendication 3, dans lequel le matériau électriquement conducteur est une encre, une peinture ou des particules conductrices.

5. Dispositif selon l'une quelconque des revendications précédentes, dans lequel la propriété électrique surveillée est une valeur de résistance.

6. Dispositif selon l'une quelconque des revendications précédentes, dans lequel le circuit électronique de traitement (300) est monté sur le corps de fixation (110) de la ventouse.

7. Dispositif selon l'une quelconque des revendications précédentes, dans lequel la piste électriquement conductrice (200) a une forme de bande.

8. Dispositif selon l'une quelconque des revendications 1 à 6, dans lequel la piste électriquement conductrice (200) a une forme surfacique.

9. Dispositif selon l'une quelconque des revendications précédentes, comprenant plusieurs ventouses (100) pourvues chacune d'une piste électriquement conductrice (200) et d'un circuit électronique de traitement (300) relié aux pistes conductrices de la ventouse.

10. Dispositif selon l'une quelconque des revendications précédentes, dans lequel le circuit électronique de traitement (300) est pourvu d'un organe de connexion à une unité électronique de commande (40) du dispositif.

11. Dispositif selon l'une quelconque des revendications précédentes, dans lequel le circuit électronique de traitement (300) est agencé pour diagnostiquer un état de la ventouse en comparant une courbe résistive de référence de la piste électriquement conductrice (200) et une courbe résistive mesurée de la piste conductrice en cours de fonctionnement du dispositif.

12. Dispositif selon l'une quelconque des revendications précédentes, dans lequel le circuit électronique de traitement (300) est agencé pour mesurer périodiquement la résistance de la piste conductrice 200, identifier un cycle de déformation à partir de l'évolution de la valeur de résistance mesurée, déterminer un nombre de cycles de déformations déjà effectués, comparer les valeurs de résistance mesurées pour ce nombre de cycles de déformation aux données de référence et émettre une alerte quand le nombre de cycles de déformation atteint un seuil prédéterminé et/ou quand les valeurs de résistance mesurées sont différentes de celles des données de référence.

## Patentansprüche

1. Vakuumgreifvorrichtung, umfassend mindestens einen Saugnapf (100), der einen Befestigungskörper (110) umfasst, von dem ab sich eine elastisch verformbare Schürze (120) erstreckt, die einen ringförmigen freien Rand (122) hat, der dazu bestimmt ist, mit einem zu greifenden Objekt in Kontakt zu kommen, wobei der Saugnapf mindestens eine elektrisch leitende Bahn (200) umfasst, die mit mindestens der Schürze fest verbunden ist, wobei die leitende Bahn aus einem elastisch leitenden Material und elastisch verformbar ist, um sich mit der Schürze zu verformen, wobei die Vorrichtung eine elektronische Verarbeitungsschaltung (300) umfasst, die elektrisch mit zwei Verbindungsbereichen (210) verbunden ist, die zur elektrisch leitenden Bahn gehören und die ausgebildet ist, eine elektrische Eigenschaft der leitenden Bahn zu überwachen, wobei sich die elektrische Eigenschaft mit der Verformung der leitenden Bahn ändert, und sie mit Referenzdaten zu vergleichen, um ein Versagen des Saugnapfes zu antizipieren.

2. Vorrichtung nach Anspruch 1, bei der die Verbindungsbereiche (210) der leitenden Bahn (200) fest mit dem Befestigungskörper (110) verbunden sind.

3. Vorrichtung nach Anspruch 1 oder Anspruch 2, bei dem die Schürze (120) einen Hauptteil umfasst, mit ringförmiger Form, aus einem elastisch verformbaren Material und elektrisch isolierend, und die elektrisch leitende Bahn (200) eine Schicht aus elektrisch leitendem Material umfasst, die auf dem Hauptteil befestigt ist.

4. Vorrichtung nach Anspruch 3, bei der das elektrisch leitende Material eine Tinte, eine Farbe oder leitfähige Partikel sind.

5. Vorrichtung nach einem der vorhergehenden Ansprüche, bei der die überwachte elektrische Eigenschaft ein Widerstandswert ist.

6. Vorrichtung nach einem der vorhergehenden Ansprüche, bei der die elektronische Verarbeitungsschaltung (300) auf dem Befestigungskörper (110) des Saugnapfes montiert ist.

7. Vorrichtung nach einem der vorhergehenden Ansprüche, bei der die elektrisch leitende Bahn (200) eine Bandform hat.

8. Vorrichtung nach einem der vorhergehenden Ansprüche 1 bis 6, bei der die elektrisch leitende Bahn (200) eine flächenhafte Form hat.

9. Vorrichtung nach einem der vorhergehenden Ansprüche, umfassend mehrere Saugnäpfe (100), die jeweils mit einer elektrisch leitenden Bahn (200) und einer elektronischen Verarbeitungsschaltung (300) versehen sind, die mit den leitenden Bahnen des Saugnapfs verbunden ist.

10. Vorrichtung nach einem der vorhergehenden Ansprüche, bei der die elektronische Verarbeitungsschaltung (300) mit einem Organ zur Verbindung mit einer elektronischen Steuereinheit (40) der Vorrichtung versehen ist.

11. Vorrichtung nach einem der vorhergehenden Ansprüche, bei der die elektronische Verarbeitungsschaltung (300) ausgebildet ist, einen Zustand des Saugnapfes zu diagnostizieren, indem eine Referenzwiderstandskurve der elektrisch leitenden Bahn (200) und eine gemessene Widerstandskurve der leitenden Bahn während des Betriebs der Vorrichtung verglichen wird.

12. Vorrichtung nach einem der vorhergehenden Ansprüche, bei der die elektronische Verarbeitungsschaltung (300) ausgebildet ist, periodisch den Widerstand der leitenden Bahn (200) zu messen, einen Verformungszyklus anhand der Entwicklung des gemessenen Widerstandswerts zu identifizieren, eine Anzahl an bereits erfolgten Verformungszyklen zu bestimmen, die für diese Anzahl an Verformungszyklen gemessenen Widerstandswerte mit Referenzdaten zu vergleichen und einen Alarm auszusenden, wenn die Anzahl an Verformungszyklen einen vorbestimmten Schwellenwert erreicht und/oder wenn die gemessenen Widerstandswerte sich von denen der Referenzdaten unterscheiden.

## Claims

1. A vacuum gripper device comprising at least one suction cup (100) including a fastener body (110) from which there extends an elastically deformable skirt (120) having a free annular edge (122) for coming into contact with an object to be grasped, the device being **characterized in that** the suction cup includes at least one electrically conductive track (200) secured at least to the skirt, **in that** the conductive track is made of a material that is electrically conductive and elastically deformable so as to deform together with the skirt, and **in that** the device comprises an electronic processor circuit (300) that is connected electrically to two connection pads (210) belonging to the conductive track and that is arranged to monitor an electrical property of the conductive track, which electrical property varies with the deformation of the conductive track, and to compare that property with reference data so as to anticipate a failure of the suction cup.

2. A device according to claim 1, wherein the connection pads (210) of the conductive track (200) are secured to the fastener body (110).

3. A device according to claim 1 or claim 2, wherein the skirt (120) comprises a main portion of annular shape made of a material that is elastically deformable and electrically insulating, and the electrically conductive track (200) comprises a layer of electrically conductive material affixed on the main portion.

4. A device according to claim 3, wherein the electrically conductive material is a conductive ink, a conductive paint, or conductive particles.

5. A device according to any preceding claim, wherein the monitored electrical property is resistance.

6. A device according to any preceding claim, wherein the electronic processor circuit (300) is mounted on the fastener body (110) of the suction cup.

7. A device according to any preceding claim, wherein the electrically conductive track (200) is in the form of a strip.

8. A device according to any one of claims 1 to 6, wherein the electrically conductive track (200) occupies a surface area.

9. A device according to any preceding claim, comprising a plurality of suction cups (100), each provided with an electrically conductive track (200) and with an electronic processor circuit (300) connected to the conductive tracks of the suction cup.

10. A device according to any preceding claim, wherein the electronic processor circuit (300) is provided with a connection member for connecting to an electronic control unit (40) of the device.

11. A device according to any preceding claim, wherein the electronic processor circuit (300) is arranged to diagnose the state of the suction cup by comparing a reference resistance curve for the electrically conductive track (200) with a resistance curve of the conductive track as measured while the device is in operation.

12. A device according to any preceding claim, wherein the electronic processor circuit (300) is arranged to act periodically to measure the resistance of the conductive track 200, to identify a deformation cycle from variation in the measured value of the resistance, to determine the number of deformation cycles that have already been performed, to compare the measured values of resistance for this number of deformation cycles with the reference data, and to issue a warning when the number of deformation cycles reaches a predetermined threshold and/or when the measured values of resistance differ from the values of the reference data.
